**Europäisches Patentamt**

**European Patent Office**

**Office européen des brevets**

(19)

(11) Veröffentlichungsnummer : **0 071 896**
**B1**

(12) **EUROPÄISCHE PATENTSCHRIFT**

(45) Veröffentlichungstag der Patentschrift :
07.05.86

(21) Anmeldenummer : **82106867.3**

(22) Anmeldetag : **29.07.82**

(51) Int. Cl.⁴ : **G 01 N 24/08, A 61 B   5/05**

(54) **Hochfrequenz-Spulensystem für ein Kernresonanz-Abbildungsgerät.**

(30) Priorität : **12.08.81 DE 3131946**

(43) Veröffentlichungstag der Anmeldung :
**16.02.83 Patentblatt 83/07**

(45) Bekanntmachung des Hinweises auf die Patenterteilung : **07.05.86 Patentblatt 86/19**

(84) Benannte Vertragsstaaten :
**DE FR GB NL**

(56) Entgegenhaltungen :
**EP-A- 0 021 535**
**DE-A- 2 755 956**
**GB-A- 2 056 086**
**GB-A- 2 057 142**
**US-A- 3 771 055**
**Die Akte enthält technische Angaben, die nach dem Eingang der Anmeldung eingereicht wurden und die nicht in dieser Patentschrift enthalten sind.**

(73) Patentinhaber : **Siemens Aktiengesellschaft**
**Berlin und München Wittelsbacherplatz 2**
**D-8000 München 2 (DE)**

(72) Erfinder : **Siebold, Horst, Dr.**
**Starenweg 3**
**D-8520 Erlangen (DE)**

**Beschreibung**

Die Erfindung bezieht sich auf ein Hochfrequenz-Spulensystem für ein Kernresonanz-Abbildungsgerät, mit einem zur Erzeugung eines radial bezüglich der Zylinderachse eines zylindrischen Volumens ausgerichteten hochfrequenten magnetischen Wechselfeldes dienenden Spulensatz, welcher ein erstes Spulenpaar aus zwei an der das zylindrische Volumen begrenzenden Mantelfläche anliegenden und sich diametral gegenüberliegenden Spulen umfaßt, die einen ersten Stromkreis bilden. Ein solches Spulensystem ist aus der veröffentlichten europäischen Patentanmeldung EP-21 535 A1 bekannt.

Auf dem Gebiet der medizinischen Diagnostik sind Abbildungsverfahren vorgeschlagen worden, bei denen durch rechnerische oder meßtechnische Analyse integraler Protonenresonanzsignale aus der räumlichen Spindichte- und/oder Relaxationszeitenverteilung eines zu untersuchenden Körpers ein Bild ähnlich einem Röntgentomogramm konstruiert wird. Die entsprechende Methode wird auch als Zeugmatographie bzw. Kernspin-Tomographie bezeichnet (« Nature », Band 242, 1973, Seiten 190 und 191).

Zur Anwendung der Kernspinresonanz wird der zu untersuchende Körper in ein starkes homogenes Magnetfeld eingebracht. Dieses als Grundfeld dienende Magnetfeld sei in einem x-y-z-Koordinatensystem in z-Richtung orientiert. Das Grundfeld $B_{Oz}$ ist von stationären und/oder gepulsten Gradientenfeldern überlagert. Außerdem muß ein senkrecht zu dem Grundfeld angeordnetes Hochfrequenzwechselfeld vorgesehen werden, das ebenfalls möglichst homogen ist. Dieses beispielsweise in x-Richtung orientierte, zeitabhängige Hochfrequenzwechselfeld $\vec{B}_1 = B_x \vec{e}_x$ cos ωt mit einem Betrag $B_x$ in Richtung des Einheitsvektor $\vec{e}_x$ dient dazu, die Kernspinmagnetisierung des zu untersuchenden, insbesondere menschlichen Körpers aus der z-Richtung in die x, y-Ebene zu klappen. Die x, y-Komponente der so erzeugten Magnetisierung präzediert um die z-Achse und induziert in einer in x- oder y-Richtung ausgerichteten Aufnehmerspule ein elektrisches Signal, welches verstärkt und ausgewertet wird. Statt einer besonderen Aufnehmerspule kann auch die Hochfrequenz-Erregerspule zur Detektion vorgesehen werden.

Physikalisch wirksam für die Anregung der Kernspinmagnetisierung ist nur die mit der Spin-Präzession gleichsinnig rotierende Komponente, während die gegensinnig rotierende unwirksam bleibt.

In der Zeugmatographie steigt das Signal-Rausch-Verhältnis des in der Aufnehmerspule induzierten Signals mit dem verwendeten Grundfeld $B_O = 2\pi \cdot f/\gamma$ an, wobei f die entsprechende Präzessionsfrequenz der Kernspins und γ der gyromagnetische Faktor der Protonen sind. Dieser Faktor beträgt beispielsweise $\gamma = 2\pi \cdot 42,57$ MHz/Tesla für Protonen. Da die Qualität der erzeugten Schnittbilder von dem Signal-Rausch-Verhältnis abhängt, ist man bestrebt, hohe Grundfelder $B_{Oz}$ und damit hohe Frequenzen $F = \gamma \cdot B_{Oz}/2\pi$ zu erhalten (vgl. « J. Phys. E : Sci. Instrum., Vol. 13, 1980, Seiten 38 bis 44). Bei den bekannten Zeugmatographie-Apparaturen (vgl. z. B. die genannte EP) können jedoch aus physikalischen Gründen nur verhältnismäßig niedrige Frequenzen von etwa 5 MHz vorgesehen werden. Bei höheren Frequenzen machen sich nämlich Wirbelströme bemerkbar, die in dem elektrisch leitenden Material des zu untersuchenden Körpers induziert werden. Auch das Gewebe von lebenden, biologischen Körpern mit einer Leitfähigkeit κ ≈ 0,5 $\Omega^{-1}$/m kann in dieser Hinsicht als elektrisch leitend angesehen werden. Diese Wirbelströme schwächen das Hochfrequenzfeld im Körperinneren wegen des Skin-Effektes und machen es inhomogen. Eine Erhöhung der Frequenzen und damit des Signal-Rausch-Verhältnisses ist somit bei den bekannten Einrichtungen der Kernspinresonanz-Technik nicht ohne weiteres möglich.

Aufgabe der vorliegenden Erfindung ist es deshalb, das Hochfrequenz-Spulensystem für ein Kernresonanz-Abbildungsgerät der eingangs genannten Art so auszugestalten, daß ein verhältnismäßig hohes Signal-Rausch-Verhältnis ermöglicht wird, indem entsprechend hohe Frequenzen von beispielsweise 20 MHz oder höher anwendbar sind.

Diese Aufgabe wird erfindungsgemäß dadurch gelöst, daß

— der Spulensatz mindestens ein zweites Spulenpaar aus zwei an der Mantelfläche oder einer zu dieser koaxialen weiteren Mantelfläche anliegenden und sich diametral gegenüberliegenden Spulen umfaßt, die einen zweiten Stromkreis bilden,

— die Spulenpaare so ausgebildet und in Umfangsrichtung der Mantelfläche bzw. Mantelflächen so gegeneinander versetzt angeordnet sind, daß sich bei Beaufschlagung der beiden Stromkreise mit hochfrequentem Wechselstrom im wesentlichen jeweils gleicher Größe, aber vorgegebener unterschiedlicher Phasenlage eine zirkulare Polarisation des von dem Spulensatz im zylindrischen Volumen erzeugten hochfrequenten magnetischen Wechselfeldes ergibt.

Die mit dieser Gestaltung des Spulensystems erreichten Vorteile sind insbesondere darin zu sehen, daß das zirkular polarisierte Hochfrequenzfeld ein besseres Eindringverhalten in den zu untersuchenden Körper als ein linear polarisiertes Hochfrequenzfeld zeigt, wie es im allgemeinen bei bekannten Einrichtungen der Kernspinresonanz-Technik vorgesehen wird. Der Feldstärkenabfall ist nämlich bei Frequenzen z. B. über 20 MHz für ein zirkular polarisiertes Feld wesentlich geringer als für ein gerichtetes, linear polarisiertes Feld. Dies bedeutet, daß hohe Frequenzen in dieser Größenordnung vorgesehen werden können, so daß dann das Signal-Rausch-Verhältnis eines Kernresonanz-Abbildungsgerätes entsprechend hoch ist.

Für eine weitere Lösung der genannten Aufgabe wird von einem Hochfrequenz-Spulensystem für ein Kernresonanz-Abbildungsgerät ausgegangen, das einen zur Erzeugung eines radial bezüglich der Zylinderachse eines zylindrischen Volumens ausgerichteten hochfrequenten magnetischen Wechselfeldes dienenden Spulensatz enthält, welcher ein erstes Spulenpaar aus zwei an der das zylindrische Volumen begrenzenden Mantelfläche anliegenden Spulen umfaßt, die einen ersten Stromkreis bilden.

Für ein solches Hochfrequenz-Spulensystem besteht die erfindungsgemäße Lösung der Aufgabe darin, daß

— der Spulensatz mindestens ein zweites Spulenpaar aus zwei an der Mantelfläche oder einer zu dieser koaxialen weiteren Mantelfläche anliegenden Spulen umfaßt, die einen zweiten Stromkreis bilden,

— die beiden Spulen eines jeden Spulenpaares jeweils in schräg zur Zylinderachse verlaufenden Schnittebenen des zylindrischen Volumens liegen, so daß die Spulen ellipsenförmig sind, wobei die beiden Schnittebenen eines jeden Spulenpaares miteinander einen vorgegebenen Winkel einschließen und ihre Schnittlinie die Zylinderachse jeweils senkrecht im gleichen Punkt schneidet, und

— die Winkel zwischen den Schnittlinien der Schnittebenen jedes Spulenpaares so bestimmt sind, daß sich bei Beaufschlagung der von den Spulenpaaren gebildeten Stromkreise mit hochfrequentem Wechselstrom im wesentlichen jeweils gleicher Größe, aber vorgegebener unterschiedlicher Phasenlage eine zirkulare Polarisation des von dem Spulensatz im zylindrischen Volumen erzeugten hochfrequenten magnetischen Wechselfeldes ergibt.

Mit dieser Ausbildung des Hochfrequenz-Spulensystems sind ebenfalls die vorstehend erläuterten Vorteile verbunden.

Vorteilhafte Ausgestaltungen der Spulensysteme nach der Erfindung gehen aus den abhängigen Ansprüchen hervor.

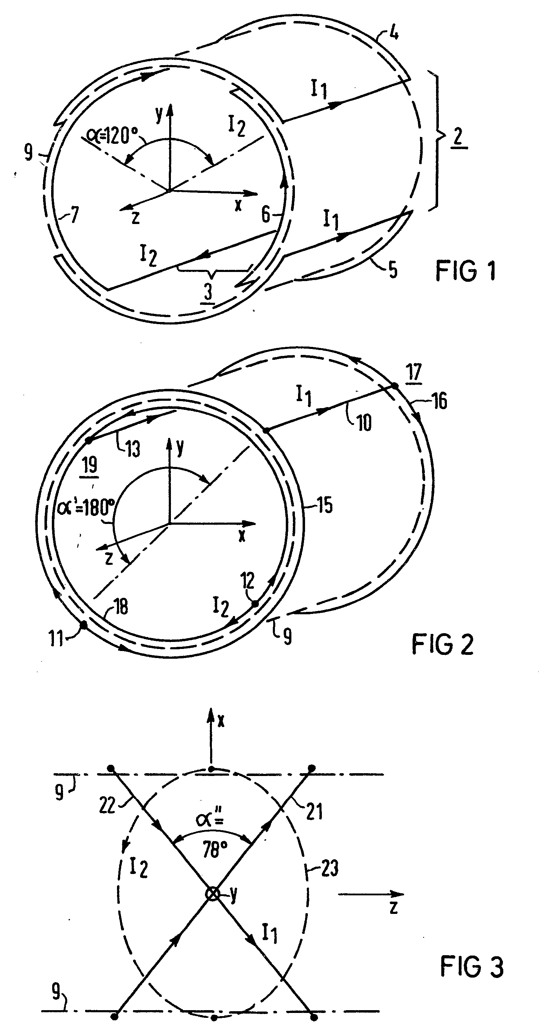

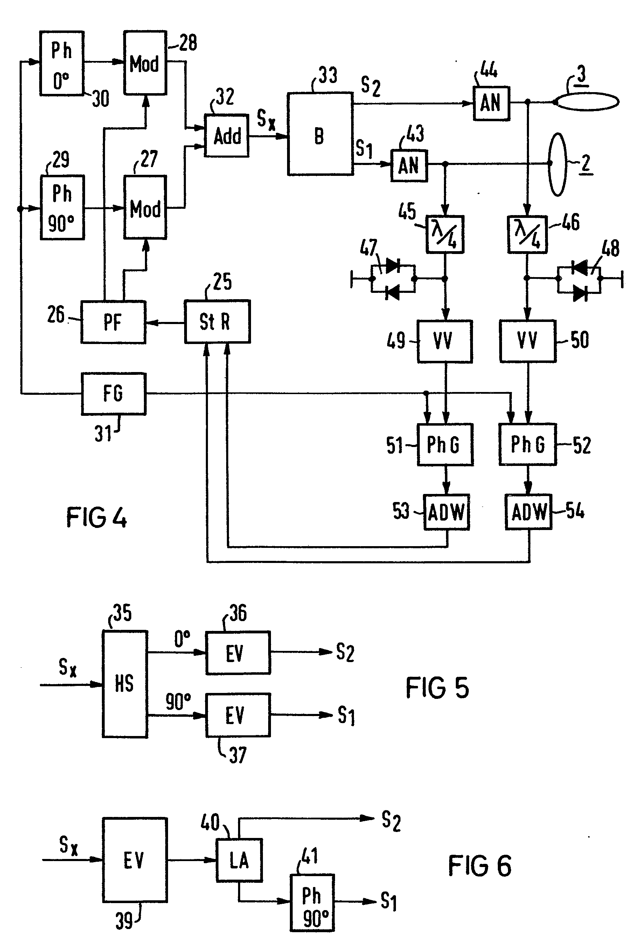

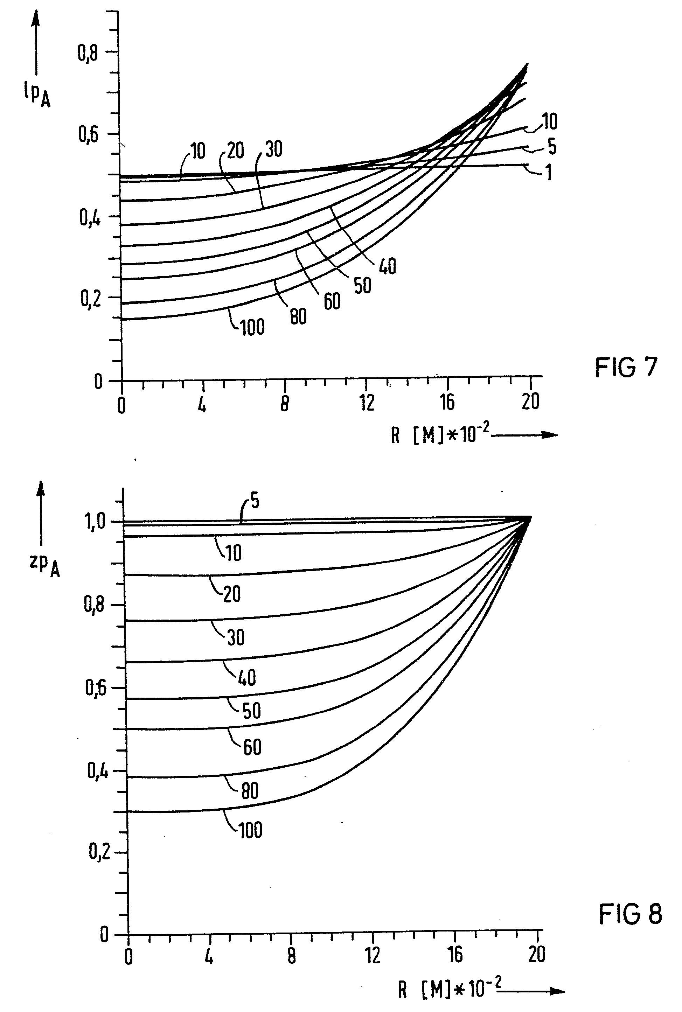

Zur weiteren Erläuterung der Erfindung wird auf die Zeichnung verwiesen, in deren Fig. 1 und 2 je ein erfindungsgemäßes Spulensystem für ein Abbildungsgerät der Kernspinresonanz-Technik angedeutet ist. Fig. 3 zeigt ein weiteres Ausführungsbeispiel eines erfindungsgemäßen Spulensystems. In Fig. 4 ist ein Blockschaltbild eines Abbildungsgerätes der Kernspinresonanz-Technik mit einem Hochfrequenz-Spulensystem nach der Erfindung veranschaulicht. In den Fig. 5 und 6 sind Teile dieses Blockschaltbildes nach Fig. 4 näher ausgeführt. In den Fig. 7 und 8 sind jeweils in einem Diagramm der radiale Verlauf der wirksamen Komponente des Hochfrequenzfeldes eines bekannten bzw. eines erfindungsgemäßen Spulensystems gegenübergestellt.

Bei dem Abbildungsgerät der Kernspinresonanz-Technik, insbesondere zur Zeugmatographie, für welches das Spulensystem nach der Erfindung vorgesehen sein soll, wird von bekannten Spulenanordnungen ausgegangen. Eine entsprechende Spulenanordnung ist z. B. in der DE-A-2 840 178 oder in der EP-21 535 A1 dargestellt. Diese Spulenanordnung hat mindestens ein bezüglich der z-Achse eines rechtwinkligen x-y-z-Koordinatensystems konzentrisch angeordnetes normal- oder supraleitendes Feldspulensystem zur Erzeugung eines homogenen magnetischen Grundfeldes in z-Richtung sowie Gradientenspulen zur Erzeugung hinreichend konstanter magnetischer Feldgradienten. Die Spulenanordnung erlaubt einen axialen Zugang zum homogenen Feldbereich in ihrem Zentrum ; d. h. der zu untersuchende, beispielsweise menschliche Körper wird längs der z-Achse in das hervorgerufene Magnetfeld eingebracht. Die Anregung der Kernspins erfolgt mittels eines senkrecht zur z-Achse gerichteten Hochfrequenzfeldes. Dieses Feld wird von einem Satz von Spulen erzeugt, die z. B. auf mindestens einem zentrischen Trägerkörper aufgebracht oder quasi selbsttragend auf mindestens einem gedachten Zylinder angeordnet sind. Daneben können die somit an einer ein zylindrisches Volumen begrenzenden Mantelfläche anliegenden Spulen auch als Empfängerspulen zur Aufnahme der Kernresonanzsignale dienen ; andernfalls wäre noch eine ähnliche Konfiguration als Empfängersystem konzentrisch z. B. innerhalb oder außerhalb eines Spulenträgerkörpers vorzusehen. Sowohl die Gradientenspulen als auch die Hochfrequenzspulen umgreifen den zu untersuchenden Körper im Bereich des Feldspulensystems.

Für ein solches Abbildungsgerät der Kernresonanz-Technik kann vorteilhaft das Spulensystem nach der Erfindung zur Erzeugung eines Hochfrequenzfeldes vorgesehen werden, wie es aus der Schrägansicht der Fig. 1 zu entnehmen ist. Das Spulensystem umfaßt zwei Paare 2 und 3 von Spulen 4, 5 bzw. 6, 7. Die Spulen 4 und 5 des Spulenpaares 2 sind auf der Außenseite eines durch gestrichelte Linien angedeuteten Trägerkörpers 9 angeordnet, während sich die Spulen 6 und 7 des zweiten Leiterpaares 3 auf der Innenseite dieses Trägerkörpers befinden. Der Trägerkörper 9 ist hohlzylindrisch gestaltet. Seine Zylinderachse soll in z-Richtung eines rechtwinkligen x-y-z-Koordinatensystems weisen. Die Magnetspulen 4 bis 7 sind sattelförmig gestaltet und haben jeweils eine Öffnungswinkel $\alpha$ in der x-y-Ebene von 120°. Die Spulen 4, 5 bzw. 6, 7 jedes Spulenpaares sind diametral zueinander auf der Außenmantel- bzw. Innenmantelfläche des Trägerzylinders 9 angeordnet, wobei das Leiterspulenpaar 2 gegenüber dem Leiterspulenpaar 3 in Umfangsrichtung um 90° verdreht ist. Somit überlappen sich die Spulen der Spulenpaare an ihren Randzonen. Gemäß einem Merkmal der Erfindung sollen die Spulen 4 und 5 des Spulenpaares 2 mit einem Hochfrequenzstrom $I_1$ gespeist werden, der um einen Phasenwinkel von 90° phasenverschoben gegenüber dem Strom $I_2$

ist, welcher durch die Spulen 6 und 7 des zweiten Spulenpaares 3 fließt. Die Beträge der Ströme $I_1$ und $I_2$ sollen dabei zumindest annähernd gleich sein. Auf diese Weise wird in dem von dem Trägerzylinder 9 umschlossenen Innenraum ein weitgehend homogenes, zirkular polarisiertes Hochfrequenzfeld erzeugt.

Statt des Öffnungswinkels $\alpha$ von 120° gemäß dem in Fig. 1 gezeigten Ausführungsbeispiel eines erfindungsgemäßen Spulensystems kann man auch andere Werte für $\alpha$ wie z. B. 90° vorsehen.

Aus der Schrägansicht der Fig. 2 geht ein weiteres Spulensystem nach der Erfindung hervor. Dieses herstellungstechnisch gegenüber dem Spulensystem nach Fig. 1 einfachere System läßt sich aus dem Spulensystem nach Fig. 1 dadurch erhalten, daß man dessen Öffnungswinkel $\alpha$ von 120° auf nunmehr $\alpha' = 180°$ erweitert. Die geraden, parallel zur z-Richtung laufenden, einander benachbarten Leiterstücke der beiden Sattelspulen eines Spulenpaares können so zu gemeinsamen Leiterstücken 10, 11 bzw. 12, 13 zusammengefaßt werden. An den Stirnseiten ist für jedes Spulenpaar ein zusätzlicher Leiterring erforderlich. In der Schrägansicht der Figur sind nur die beiden Leiterringe 15 und 16 des ersten Spulenpaares 17 sowie ein Leiterring 18 des zweiten Spulenpaares 19 ersichtlich. Die Flußrichtungen der Ströme $I_1$ und $I_2$ in den einzelnen Spulenpaaren sind durch Pfeile an den ihre Leiter darstellenden Linien veranschaulicht. Der Strom $I_1$ ist dabei gegenüber dem Strom $I_2$ um 90° phasenverschoben. Dieses Spulensystem hat vorteilhaft gegenüber dem Spulensystem nach Fig. 1 einen geringeren ohmschen Widerstand und damit eine entsprechend höhere Spulengüte. Außerdem haben die Leiter in seinen beiden Spulenpaaren 17 und 19 nur vier Kreuzungspunkte, falls die beiden Spulenpaare auf die Außenfläche des sie tragenden Zylinders 9 aufgebracht werden. Im Gegensatz dazu ergeben sich bei dem Spulensystem nach Fig. 1 acht Kreuzungspunkte bei außenseitiger Befestigung.

Neben den in den Fig. 1 und 2 dargestellten Ausführungsformen von Spulensystemen nach der Erfindung können die auf einen zylindrischen Trägerkörper aufzubringenden Spulen der Spulenpaare auch andere geometrische Gestalt haben. So lassen sich beispielsweise für jedes Spulenpaar Spulen in Form von zwei sich kreuzenden Ellipsen verwenden. Ein Ausführungsbeispiel eines entsprechenden Spulenpaares ist in Fig. 3 als Aufsicht in Richtung der y-Achse eines rechtwinkligen x-y-z-Koordinatensystems dargestellt. Auf der Außenmantelfläche eines durch strichpunktierte Linien angedeuteten Trägerzylinders 9, dessen Zylinderachse in z-Richtung weist, ist ein Spulenpaar mit zwei sich kreuzenden, elliptischen Spulen 21 und 22 angeordnet. Der Öffnungs- bzw. Kreuzungswinkel $\alpha''$ zwischen den Spulen beträgt etwa 78°. Für die Erzeugung des zirkular polarisierten Hochfrequenzfeldes gemäß der Erfindung ist ein zusätzliches, um 90° bzgl. der z-Achse gedrehtes Spulenpaar erforderlich, das z. B. auf der Innenmantelfläche des Trägerzylinders 9 angeordnet wird. Die Spulen dieses Spulenpaares sind in der Aufsicht der Figur durch eine gestrichelte Linie 23 angedeutet. Die durch Pfeile angedeuteten Flußrichtungen der Ströme $I_1$ und $I_2$ in den beiden Spulenpaaren sind wiederum um 90° phasenverschoben.

Bei den in den Fig. 1 bis 3 dargestellten Ausführungsformen von Hochfrequenz-Spulensystemen nach der Erfindung wurde davon ausgegangen, daß auf einer oder mehreren konzentrischen Zylindermantelflächen zwei in Umfangsrichtung des Zylinders gesehen um 90° verdreht angeordnete Spulenpaare vorgesehen werden, um mit diesen Spulenpaaren ein zirkular polarisiertes Hochfrequenzfeld bei Abwesenheit eines leitenden Körpers zu erzeugen, wobei die Ströme in den beiden Spulenpaaren um 90° phasenverschoben sind. Um ein solches Hochfrequenzfeld zu erzeugen, ist es jedoch gegebenenfalls auch möglich, eine höhere Anzahl von Spulenpaaren vorzusehen, wobei dann der Phasenwinkel ihrer Ströme entsprechend verringert werden muß.

In Fig. 4 sind die wesentlichsten Teile eines Blockschaltbildes eines Abbildungsgerätes der Kernspinresonanz-Technik, insbesondere der Zeugmatographie, mit einem Spulensystem gemäß der Erfindung zur Erzeugung eines Hochfrequenzfeldes angedeutet. Ein Steuerrechner (StR) 25 kontrolliert den Gesamtablauf.

Er erzeugt mit Hilfe eines Pulsformers (PF) 26 pulseinhüllende Modulationssignale für Einseitenband-Modulatoren (Mod) 27 und 28, die ihrerseits über Phasenschieber (Ph) 29 und 30 mit den Grundfrequenzen aus einem hochstabilen Frequenzgenerator (FG) 31 versorgt werden. Nach einem Addierer (Add) 32 steht dann ein Hochfrequenzsignal $S_x$ zur Verfügung. Die Erzeugung zweier um 90° phasenverschobener Einspeisungen, wie es für ein Spulensystem nach der Erfindung erforderlich ist, kann auf zwei verschiedene Arten in einem Block (B) 33 erfolgen. Diese beiden Arten sind in den Schaltbildern der Fig. 5 und 6 angedeutet. Nach Fig. 5 wird das Ansteuersignal $S_x$ zuerst in einer Hybridschaltung (HS) 35 in zwei phasenverschobene Anteile aufgespalten und anschließend in zwei getrennten Endverstärkern (EV) 36 und 37 verstärkt, so daß zwei phasenverschobene Signale $S_1$ und $S_2$ erhalten werden. Gemäß dem Schaltbild nach Fig. 6 wird zuerst das Ansteuersignal $S_x$ endverstärkt, so daß nur ein Endverstärker (EV) 39 erforderlich ist, der für die doppelte Leistung verglichen mit den Endverstärkern 36 und 37 nach Fig. 5 ausgelegt sein muß. Außerdem müssen ein Leistungsaufteiler (LA) 40 und ein Phasenschieber (Ph) 41 auf eine Endleistung $S_1$ ausgelegt sein. Die installierte Endverstärkerleistung ist bei den in den Fig. 5 und 6 gezeigten Varianten gleich; sie beträgt insgesamt nur die Hälfte der zu installierenden Leistung bei Verwendung eines einzigen Frequenzspulenpaares gemäß dem Stand der Technik.

Nach Fig. 4 werden die Leistungssignale $S_1$

und $S_2$ des oder der Endverstärker über Anpassungnetzwerke (AN) 43 und 44 an die beiden resonant abgestimmten Spulenpaare 2 bzw. 3 abgegeben. Diese Spulenpaare werden auch als Empfangsspulen verwendet, wodurch sich das Hochfrequenzsignal um den Faktor 2 und das Signal-Rausch-Verhältnis um den Faktor $\sqrt{2}$ verbessert. Eine Viertelwellenlängenstrecke ($\lambda$/4) 45 bzw. 46 mit Diodenabschluß 47 bzw. 48 dient als selbstgesteuerter Umschalter von Sendebetrieb auf Empfangsbetrieb. Beim Senden sind die Dioden wegen der hohen Spannungen aufgesteuert und wirken durch ihren Kurzschluß als Leistungsreflektor, während beim Empfang der schwachen Signale die Dioden hochohmig sind. Mittels Vorverstärkern (VV) 49 und 50 wird das Empfangssignal verstärkt. In phasenempfindlichen Gleichrichtern (PhG) 51 und 52, die ihr Referenzsignal von dem Frequenzgenerator 31 erhalten, wird die Hochfrequenz auf Niederfrequenz transformiert. Nach einer Digitalisierung in entsprechenden Geräten (ADW) 53 und 54 können dann die Signale im Steuerrechner 25 in bekannter Weise weiterverarbeitet werden.

Abweichend von dem Blockschaltbild gemäß den Fig. 4 bis 6 kann man statt der zwei getrennten Vorverstärker 49 und 50 eine Phasenverschiebung einer Signalleitung, z. B. von der Spule 3 nach dem Diodenschalter 48 über einen Phasenschieber, der dem Phasenschieber 29 entspricht, vorsehen. Das so phasenverschobene Signal wird dann über einen Addierer wie Bauteil 32 zu dem Signal der Spule 2 hinzuaddiert. Für das Summensignal ist dann nur noch ein einziger Vorverstärker 49 und ein phasenempfindlicher Gleichrichter 51 erforderlich.

Betrachtet man den zu untersuchenden, z. B. menschlichen Körper näherungsweise als nichtmagnetischen, homogen leitenden Zylinder, dem Zylinderkoordinaten z, r und $\varphi$ zugeordnet sind, so ist bekanntlich das Feld im Körperinneren nicht mehr homogen, sondern eine Funktion der Zylinderkoordinaten r und $\varphi$. Ferner ist für die Anregung der Kernspinmagnetisierung nur die mit der Spinpräzession gleichsinnig rotierende Komponente des Hochfrequenzfeldes physikalisch wirksam, während die gegensinnig rotierende unwirksam bleibt. Bestimmt man nun die radiale Abhängigkeit der wirksamen rotierenden Komponente des Hochfrequenzfeldes bei einem in x-Richtung linear polarisierten erregende Feld, wie es bei bekannten Einrichtungen der Kernspinresonanz-Technik vorgesehen wird, so ergibt sich für ein Ausführungsbeispiel der in Fig. 7 in einem Diagramm gezeigte Kurvenverlauf. In dem Diagramm ist auf der Ordinate als Amplitude $^{lp}A$ die relative Komponente $^{lp}B_\omega/B_1$ aufgetragen, wobei $^{lp}B_\omega$ die Amplitude der mit der Kreisfrequenz $\omega$ rotierenden Komponente des linear polarisierten Hochfrequenzfeldes und $B_1$ die Amplitude des äußeren homogenen Wechselfeldes in x-Richtung bei Abwesenheit eines zu untersuchenden, leitenden Körpers sind. Als zu untersuchender Körper ist ein Zylinder mit einem Radius R von 0,2 m und einer Leitfähigkeit $\kappa$ = 0,5

$\Omega^{-1}$/m angenommen. Da bei linear polarisierten Hochfrequenzfeldern eine Abhängigkeit von der Zylinderkoordinate $\varphi$ besteht, ist außerdem ein gegen die x-Achse geneigter Schnittwinkel $\varphi$ von 45° des Aufpunktstrahles angenommen. Bei diesem Winkel ist nämlich der radiale Abfall der Amplitude am stärksten. In dem Diagramm sind sich für verschiedene Frequenzen ergebende Kurven eingetragen, wobei die jeweiligen Frequenzen in MHz an den einzelnen Kurven angegeben sind. Wie aus dem Diagramm zu entnehmen ist, beträgt bei einer Frequenz von beispielsweise 20 MHz die Amplitude der wirksamen Feldstärke im Zentrum des gewählten Zylinders nur noch 67 % des Wertes am Rande. Das bedeutet aber, daß die Variation der Feldstärke bezüglich des Winkels $\varphi$ des zylindrischen Körpers zu erheblichen Signal- und damit zu entsprechenden Bildstörungen führen kann.

Gemäß einem Merkmal der Erfindung ist deshalb ein weiteres Spulenpaar vorgesehen, das zusätzlich ein homogenes Wechselfeld in y-Richtung erzeugt. Dieses Spulenpaar wird mit einem Strom gleicher Stärke, jedoch mit einer Phasenverschiebung von 90° gegenüber dem Strom in dem ersten Spulenpaar gespeist. Im Außenraum ergibt sich dann bei Abwesenheit eines leitenden Körpers ein homogenes, zirkular polarisiertes Magnetfeld. Für die Anregung der Kernspinmagnetisierung ist ebenfalls nur die mit der Frequenz $\omega$ rotierende Komponente $^{zp}B_\omega$ wirksam. Jedoch ist der Betrag dieser Komponente im Gegensatz zu den bekannten linear polarisierten Hochfrequenzfeldern nicht mehr abhängig von der Zylinderkoordinate $\varphi$. In dem Diagramm der Fig. 8 ist als Amplitude $^{zp}A$ der auf die Größe $B_1$ normierte Betrag $^{zp}B_\omega$ als Funktion des Radius R für verschiedene Frequenzen bildlich dargestellt. Bis auf das verschiedene Hochfrequenzfeld sind dabei die gleichen Annahmen wie bei dem Ausführungsbeispiel gemäß dem Diagramm der Fig. 7 zugrundegelegt. Wie aus dem Diagramm der Fig. 8 zu entnehmen ist, fällt bei einer Frequenz von 20 MHz die Amplitude der rotierenden Komponente lediglich auf einen Wert von 87 % des Randwertes ab. Dies bedeutet, daß die räumliche Variation der wirksamen rotierenden Hochfrequenzkomponente sich mit den Maßnahmen nach der Erfindung gegenüber bekannten Spulensystemen mit einem linear polarisierten Hochfrequenzfeld wesentlich verringert hat. Durch das zirkular polarisierte Hochfrequenzfeld des Spulensystems nach der Erfindung wird also ein wesentlich günstigeres Eindringverhalten der wirksamen rotierenden Hochfrequenzkomponente erreicht als bei linear polarisiertem Feld.

**Patentansprüche**

1. Hochfrequenz-Spulensystem für ein Kernresonanz-Abbildungsgerät, mit
— einem zur Erzeugung eines radial bezüglich der Zylinderachse eines zylindrischen Volumens ausgerichteten hochfrequenten magnetischen Wechselfeldes dienenden Spulensatz, welcher ein erstes Spulenpaar (2, 17) aus zwei an der das zylindrische Volumen begrenzenden Mantelfläche (9) anliegenden und sich diametral gegenüberliegenden Spulen (4, 5 ; 10, 11, 15, 16) umfaßt, die einen ersten Stromkreis bilden, dadurch gekennzeichnet, daß

— der Spulensatz mindestens ein zweites Spulenpaar (3 ; 19) aus zwei an der Mantelfläche (9) oder einer zu dieser koaxialen weiteren Mantelfläche anliegenden und sich diametral gegenüberliegenden Spulen (6, 7 ; 12, 13, 18) umfaßt, die einen zweiten Stromkreis bilden,

— die Spulenpaare (2, 3 ; 17, 19) so ausgebildet und in Umfangsrichtung der Mantelfläche bzw. Mantelflächen so gegeneinander versetzt angeordnet sind, daß sich bei Beaufschlagung der beiden Stromkreise mit hochfrequentem Wechselstrom im wesentlichen jeweils gleicher Größe, aber vorgegebener unterschiedlicher Phasenlage eine zirkulare Polarisation des von dem Spulensatz im zylindrischen Volumen erzeugten hochfrequenten magnetischen Wechselfeldes ergibt.

2. Spulensystem nach Anspruch 1, dadurch gekennzeichnet, daß die Spulen (4 bis 7) jedes Spulenpaares (2, 3) sattelförmig gestaltet sind.

3. Spulensystem nach Anspruch 1 oder 2, dadurch gekennzeichnet, daß der radiale Öffnungswinkel (α) jeder Spule (4 bis 7) der Spulenpaare (2, 3) zumindest annähernd 120° beträgt.

4. Spulensystem nach Anspruch 1 oder 2, dadurch gekennzeichnet, daß der radiale Öffnungswinkel (α) jeder Spule der Spulenpaare (2, 3) zumindest annähernd 90° beträgt.

5. Spulensystem nach Anspruch 2, dadurch gekennzeichnet, daß der radiale Öffnungswinkel (α') jeder Spule der Spulenpaare (17, 19) zumindest annähernd 180° beträgt, daß jeweils benachbarte sattelförmige Spulen aus gleichen Spulenpaaren (17, 19) an den einander zugewandten Seiten gemeinsame, sich in Richtung der Zylinderachse erstreckende geradlinige Leiterstücke (10 bis 13) haben und daß an ihren Stirnseiten ihre gebogenen Leiterstücke zu jeweils einem geschlossenen Ring (15, 16 bzw. 18) ausgebildet sind.

6. Hochfrequenz-Spulensystem für ein Kernresonanz-Abbildungsgerät, mit

— einem zur Erzeugung eines radial bezüglich der Zylinderachse eines zylindrischen Volumens ausgerichteten hochfrequenten magnetischen Wechselfeldes dienenden Spulensatz, welcher ein erstes Spulenpaar aus zwei an der das zylindrische Volumen begrenzenden Mantelfläche (9) anliegenden Spulen (21, 22) umfaßt, die einen ersten Stromkreis bilden, dadurch gekennzeichnet, daß

— der Spulensatz mindestens ein zweites Spulenpaar aus zwei an der Mantelfläche (9) oder einer zu dieser koaxialen weiteren Mantelfläche anliegenden Spulen (23) umfaßt, die einen zweiten Stromkreis bilden,

— die beiden Spulen eines jeden Spulenpaares jeweils in schräg zur Zylinderachse verlaufenden Schnittebenen des zylindrischen Volumens liegen, so daß die Spulen ellipsenförmig sind, wobei die beiden Schnittebenen eines jeden Spulenpaares miteinander einen vorgegebenen Winkel (α'') einschließen und ihre Schnittlinie die Zylinderachse jeweils senkrecht im gleichen Punkt schneidet, und

— die Winkel zwischen den Schnittlinien der Schnittebenen jedes Spulenpaares so bestimmt sind, daß sich bei Beaufschlagung der von den Spulenpaaren gebildeten Stromkreise mit hochfrequentem Wechselstrom im wesentlichen jeweils gleicher Größe, aber vorgegebener unterschiedlicher Phasenlage eine zirkulare Polarisation des von dem Spulensatz im zylindrischen Volumen erzeugten hochfrequenten magnetischen Wechselfeldes ergibt.

7. Spulensystem nach einem der Ansprüche 1 bis 6, dadurch gekennzeichnet, daß die Spulen (6, 7 ; 23) des einen Spulenpaares (3) auf der Innenmantelfläche eines hohlzylindrischen Trägerkörpers (9) und die Spulen (4, 5 ; 21, 22) des anderen Spulenpaares (2) auf der Außenmantelfläche dieses Trägerkörpers (9) angeordnet sind.

## Claims

1. A high-frequency coil system for a nuclear-resonance imaging device, with

— a set of coils to produce a high-frequency, alternating magnetic field radially aligned in relation to the cylindrical axis of a cylindrical volume, where the coil set comprises a first pair of coils (2 ; 17) consisting of two diametrically opposed coils (4, 5 ; 10, 11, 15, 16) which contact the surface (9) defining the cylindrical volume and form a first circuit, characterised in that

— the coil set comprises at least one second pair of coils (3 ; 19) consisting of two diametrically opposed coils (6, 7 ; 12, 13, 18) which contact the surface (9) or a further surface coaxial with the first surface and form a second circuit :

— the pairs of coils (2, 3 ; 17, 19) are designed and arranged to be mutually offset in the peripheral direction of the surface or surfaces in such manner that when the two circuits are supplied with high-frequency alternating currents of fundamentally equal value but a predetermined differing phase, there is a circular polarisation of the high-frequency, alternating magnetic field produced by the coil set in the cylindrical volume.

2. A coil system as claimed in Claim 1, characterised in that the coils (4 to 7) of each pair of coils (2, 3) are saddle-shaped.

3. A coil system as claimed in Claim 1 or 2, characterised in that the radial apertural angle (α) of each coil (4 to 7) of the pairs of coils (2, 3) amounts to at least approximately 120°.

4. A coil system as claimed in Claim 1 or 2, characterised in that the radial apertural angle (α) of each coil of the pairs of coils (2, 3) amounts to at least approximately 90°.

5. A coil system as claimed in Claim 2, characterised in that the radial apertural angle ($\alpha'$) of each coil of the pairs of coils (17, 19) amounts to at least approximately 180°, that adjacent saddle-shaped coils of identical pairs of coils (17, 19) are provided, at their sides facing towards one another, with common rectilinear conductor sections (10 to 13) which extend in the direction of the cylindrical axis, and that at their ends their bent conductor sections in each case form a closed ring (15, 16 and 18).

6. A high-frequency coil system for a nuclear-resonance imaging device, with

— a coil set which serves to produce a high-frequency, alternating magnetic field radially aligned in relation to the cylindrical axis of a cylindrical volume, where the coil set comprises a first pair of coils consisting of two coils (21, 22) which contact the surface (9) defining the cylindrical volume and form a first circuit, characterised in that

— the coil set comprises at least one second pair of coils consisting of two coils (23) which contact the surface (9) or a further surface coaxial with the first surface, and form a second circuit ;

— the two coils of each pair of coils are each located in sectional planes of the cylindrical volume which extend obliquely to the cylindrical axis so that the coils are elliptical. Where the two sectional planes of each pair of coils form a predetermined angle ($\alpha''$) with one another and their intersection line intersects the cylindrical axis at right angles at the same point ; and

— the angles between the intersection lines of the sectional planes of each pair of coils are determined such that when the circuits formed by the pairs of coils are fed with high-frequency alternating current of fundamentally equal value but predetermined different phase, a circular polarisation takes place in respect of the high-frequency alternating magnetic field produced by the set of coils in the cylindrical volume.

7. A coil system as claimed in one of Claims 1 to 6, characterised in that the coils (6, 7 ; 23) of the first pair of coils (3) are arranged on the inner surface of a hollow, cylindrical carrier body (9), and the coils (4, 5 ; 21, 22) of the other pair of coils (2) are arranged on the outer surface of this carrier body (9).

**Revendications**

1. Système de bobines haute fréquence pour un appareil de visualisation ou de représentation utilisant la résonance magnétique nucléaire, comprenant

— un jeu de bobines servant à engendrer un champ magnétique alternatif haute fréquence, orienté radialement par rapport à l'axe de cylindre d'un volume cylindrique, qui possède une première paire de bobines (2 ; 17) constituée de deux bobines (4, 5 ; 10, 11, 15, 16) disposées à la surface latérale (9) délimitant le volume cylindrique et située diamétralement l'une en face de l'autre, qui forment un premier circuit électrique, caractérisé en ce que

— le jeu de bobines possède au moins une deuxième paire de bobines (3 ; 19) constituée de deux bobines (6, 7 ; 12, 13, 18) disposées à la surface latérale (9) ou à une autre surface latérale coaxiale à celle-ci et situées diamétralement l'une en face de l'autre, qui forment un second circuit électrique,

— les paires de bobines (2, 3 ; 17, 19) sont réalisées et disposées mutuellement décalées dans le sens circonférentiel de la surface latérale ou des surfaces latérales, de manière que, lorsque les deux circuits électriques sont alimentés avec des courants haute fréquence d'intensité essentiellement égale mais avec un déphasage préfixé, il s'établisse une polarisation circulaire du champ magnétique alternatif haute fréquence engendré par le jeu de bobines dans le volume cylindrique.

2. Système selon la revendication 1, caractérisé en ce que les bobines (4 à 7) de chaque paire (2, 3) sont en forme de selle.

3. Système selon la revendication 1 ou 2, caractérisé en ce que l'angle d'ouverture radiale ($\alpha$) de chaque bobine (4 à 7) des paires (2, 3) est d'au moins à peu près 120°.

4. Système selon la revendication 1 ou 2, caractérisé en ce que l'angle d'ouverture radiale ($\alpha$) de chaque bobine des paires (2, 3) est d'au moins à peu près 90°.

5. Système selon la revendication 2, caractérisé en ce que l'angle d'ouverture radiale ($\alpha'$) de chaque bobine des paires (17, 19) est d'au moins à peu près 180°, que les bobines en forme de selle voisines de la même paire (17, 19) possèdent sur leurs côtés dirigés l'un vers l'autre des tronçons de conducteurs (10 à 13) rectilignes communs s'étendant en direction de l'axe de cylindre et que leurs tronçons de conducteurs courbes sur leurs côtés extrêmes sont chaque fois conformés en un anneau fermé (15, 16 respectivement 18).

6. Système de bobines haute fréquence pour un appareil de visualisation ou de représentation utilisant la résonance magnétique nucléaire, comprenant

— un jeu de bobines servant à engendrer un champ magnétique alternatif haute fréquence, orienté radialement par rapport à l'axe de cylindre d'un volume cylindrique, qui possède une première paire de bobines constituée de deux bobines (21, 22) disposées à la surface latérale (9) délimitant le volume cylindrique, qui forment un premier circuit électrique, caractérisé en ce que

— le jeu de bobines possède au moins une deuxième paire de bobines constituée de deux bobines (23) disposées à la surface latérale (9) ou à une autre surface latérale coaxiale à celle-ci, qui forment un second circuit électrique,

— les deux bobines de chaque paire sont situées dans des plans de coupe s'étendant obliquement par rapport à l'axe de cylindre du volume cylindrique, de sorte que les bobines sont ellipsoïdales, les deux plans de coupe de chaque paire de bobines renfermant entre eux un angle (α'') préfixé et leur ligne d'intersection coupant chaque fois l'axe de cylindre perpendiculairement au même point et

— les angles entre les lignes d'intersection des plans de coupe de chaque paire de bobines sont fixés de manière que lorsque les circuits électriques formés par les paires de bobines sont alimentés avec des courants alternatifs haute fréquence d'intensité essentiellement égale mais avec un déphasage préfixé, il s'établisse une polarisation circulaire du champ magnétique alternatif haute fréquence engendré par le jeu de bobines dans le volume cylindrique.

7. Système selon une des revendications 1 à 6, caractérisé en ce que les bobines (6, 7 ; 23) d'une paire (3) sont disposées sur la surface latérale interne d'un corps de support cylindrique creux (9) et les bobines (4, 5 ; 21, 22) de l'autre paire (2) sont disposées sur la surface latérale externe de ce corps de support (9).

0 071 896

FIG 1

FIG 2

FIG 3

FIG 4

FIG 5

FIG 6

FIG 7

FIG 8